# EUROPEAN PATENT SPECIFICATION

(11) **EP 2 804 064 B1**
(45) Date of publication and mention of the grant of the patent: **01.07.2020**
(21) Application number: 13168374.0
(22) Date of filing: 17.05.2013
(51) Int. Cl.: G05B 23/02, H01H 9/00

(54) **A computerised system and method for generating a life expectancy analysis report related to a low or medium voltage switching device**
Computerisiertes System und Verfahren zur Erzeugung eines Lebenserwartungsauswertungsberichts einer Nieder- oder Mittelspannungsschaltvorrichtung
Système informatisé et procédé permettant de générer un rapport d'analyse de l'espérance de vie se rapportant à un dispositif de commutation basse ou moyenne tension

(43) Date of publication of application: 19.11.2014
(73) Proprietor: ABB S.p.A., 20124 Milano (IT)
(72) Inventor: Di Vaira, Antonio, I-24125 Bergamo (BG) (IT); Manzoni, Marco, I-24060 Bolgare (BG) (IT)
(74) Representative: De Bortoli, Eros

(56) References cited:
- EP-A2- 2 267 305
- EP-A2- 2 573 577
- US-A1- 2004 049 480
- US-A1- 2009 100 293
- US-A1- 2012 022 797
- US-A1- 2012 143 565
- US-A1- 2012 283 963

## Description

The present invention relates to a computerized system for generating a life expectancy analysis report related to a low or medium voltage switching device, such as, for example, an automatic circuit breaker.

In a further aspect, the present invention relates to a method for generating said life expectancy analysis report.

As is known, low or medium voltage switching devices are subject to relevant wear phenomena during their operating life.

The experience has shown that the wear level of a switching device mainly depends on the number of performed switching operations rather than by the age of service of said device. As a consequence, in a power distribution network switching devices having a same age of service but different wear levels are generally present.

In order to properly plan maintenance interventions on the switching devices of a power distribution network, it is thus necessary to acquire information related to the actual operating status of each device, as described in US 2012/022797 A1.

In most cases, these data may be obtained by inspecting the switching devices and/or by downloading them from the control units of the switching devices.

Setting a maintenance intervention plan requires that these data are properly processed to obtain predictive information related to the life expectancy of relevant components (e.g. the electric contacts, the arc chamber, etc.) of the switching devices.

Unfortunately, the results of a life expectancy analysis conducted on different switching devices may be inconsistent, in particular when said analysis is performed by different operators.

Further, the practice has shown how the documentation reporting the results of life expectancy analysis is often structured in such a way that data may be difficult to compare and looked-up.

Planning maintenance interventions on the switching devices may therefore be relatively difficult and time-consuming.

In the market, it is quite felt the demand for systems and methods that allow the obtaining of consistent results from a life expectancy analysis performed on the switching devices of a power distribution network and, at the same time, that allow the obtaining of documentation reporting said results, which is structured in a consistent manner and which is easy to be looked up.

Said need is particularly felt in managing power distribution networks that need a high grade of reliability (e.g. power distribution network in nuclear plants, data centres, hospitals, etc.). In order to respond to such a need, the present invention provides a computerized system for generating a life expectancy analysis report related to a low or medium voltage switching device, according to the following claim 1 and the related dependent claims.

In a further aspect, the present invention provides a method for generating a life expectancy analysis report related to a low or medium voltage switching device, according to the following claim 4 and the related dependent claim.

The computerised system and method, according to the invention, are capable to perform in an automatic manner a life expectancy analysis on a switching device, based on first data related to the operating status of said switching device.

At the same time, the computerised system and method, according to the invention, provide the results of said life expectancy analysis in an output report that has a selectable format, which allows evaluating said results in a user-friendly way.

The computerised system and method, according to the invention, provide the user with consistent data on the actual and predicted operating status of the switching devices of a power distribution network.

At the same time, the computerised system and method, according to the invention, provide the user with results that are easy to be looked-up and compared.

The computerised system and method, according to the invention, provide an effective aid to properly set a maintenance plan for the switching devices of a power distribution network with relevant savings of time and costs.

The computerised system and method, according to the invention, is easy to implement in practice by using commonly available HW/SW resources and at relatively low costs.

Further characteristics and advantages of the present invention shall emerge more clearly from the description of preferred but not exclusive embodiments of the computerised system and method, according to the invention, illustrated purely by way of example and without limitation in the attached drawings, in which:

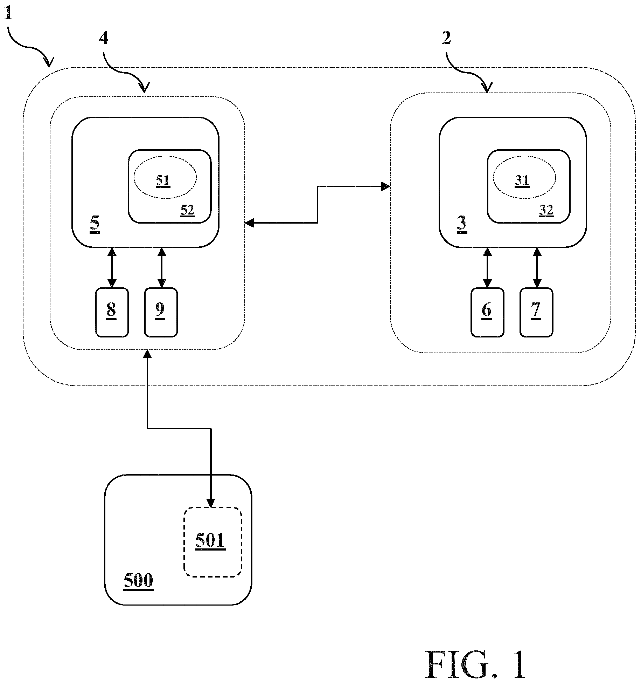

Figure 1 is a diagram that schematically illustrates the architecture of the computerised system, according to the invention, in a preferred embodiment;
Figure 2 is a diagram that schematically illustrates the processing steps executed by the computerised system and method, according to the invention.

With reference to the mentioned figures, the present invention relates to a computerized system 1 for automatically generating a life expectancy analysis report 100 related to a low or medium voltage switching device 500.

Within the framework of the present invention the term "low voltage" relates to voltages lower than 1 kV AC and 1.5 kV DC whereas the term "medium voltage" relates to voltages lower than 72 kV AC and 100 kV DC.

The switching device 500 may be of any type, such as, for example, an automatic circuit breaker of the fixed or draw-out type.

Preferably, the switching device 500 comprises a control unit 501, which may be accessed through a suitable communication port, such as a Bluetooth™ port or a Zigbee™ port or the like.

The computerized system 1 comprises a first computerized unit 2, which may be formed, for example, by one or more applicative servers or by a cloud server structure.

The computerized unit 2 comprises first computerized means 3, such as for example one or more microprocessors.

In order to operate (e.g. to perform the operations or processing steps that will be described in the following), the computerized means 3 execute suitable first software instructions 31 that are stored in suitable storing means 32 (e.g. one or more volatile or non-volatile memories) comprised in the computerized means 3.

Software instructions 31 may be permanently stored in the storing means 32 or may be uploaded for execution by the computerized means 3 from one or more external devices (not shown).

Software instructions 31 are programmed by using suitable programming languages, according to the needs, and may be comprised in one or more applicative programs that can be executed by the computerized means 3.

The computerized unit 2 comprises a user interface 6, through which a user can send data or commands to the computerized means 3 through any known way, e.g. in a wired or wireless (GPRS) manner, via the Internet, via a dedicated network, and the like.

The computerized unit 2 preferably comprises one or more communication ports 7, through which the computerized means 3 can communicate with one or more remote computerized devices.

In order to generate the life expectancy report 100, the computerized means 3 are capable to execute the processing steps 201-208 that will be described in the following.

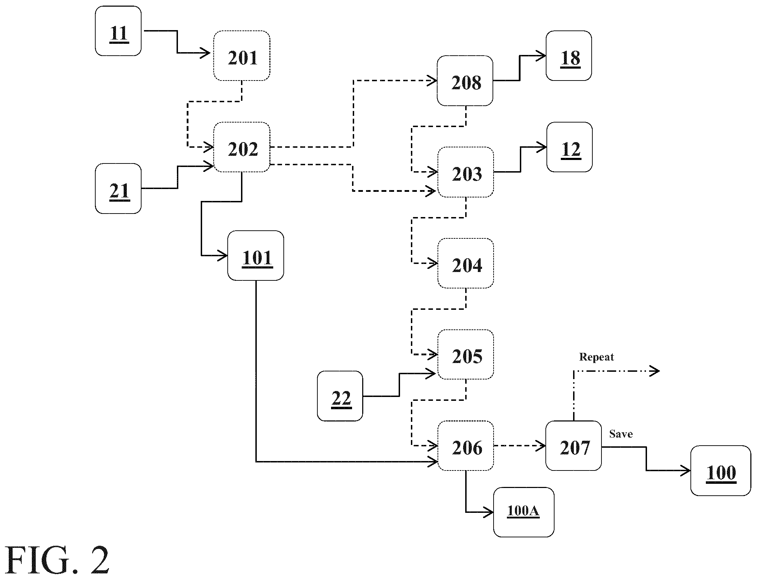

Reference is made to figure 2, in which the described processing steps are represented by dotted line boxes, whereas the pieces of information, which are acquired or generated during said processing steps, are represented by continuous line boxes.

Initially, the computerized means 3 acquire (processing step 201) first data 11 related to the operating status of the switching device 500.

First data 11 may be sent to the computerised means 3 through the user interface 6 or through a different suitable user interface device that is connected with a communication port 7 of the computerized unit 2.

According to a preferred embodiment of the present invention (which will be better described in the following), first data 11 are sent (at least partially) by a client computerized unit 4 that is capable of communicating with the computerized means 3 through a communication port 7. First data 11 may comprise data related to environmental operating conditions of the switching device 500, such as, for example, data related to the temperature of the switching device, the temperature of the control unit 501, the temperature out of the switchboard where the switching device is installed, the typical temperature variations, the duty cycle of the switching device, the environmental humidity, the presence of a salty and/or dusty environment, the presence of corrosive agents, the presence of vibrations, the geographic coordinates (including altitude), the presence of thermal shocks, arc fault conditions.

Further, first data 11 may comprise first identification data of the switching device 500, such as, for example, the serial number of the switching device, the serial number of the control unit 501, the type of switching device and control unit, the type of firmware for the control unit, the number of electric poles of the switching device, the operating settings of the switching device and control unit (e.g. the so-called L, S, I, G protection settings), the age of service of the switching device and control unit, the connected electrical loads, the kind of plant and/or switchboard where the switching device is installed, the position of the switching device in the power distribution network, the voltage of service, data related to fixed or draw-out installation.

Further, first data 11 may comprise first data related to the past operating life of the switching device 500, such as for example, the number and type of opening/closing manoeuvres operated by the switching device, the number and type of interventions commanded by the control unit 501, the wear level of the electric contacts of the switching device, the operation history of the control unit (e.g. trip history stored in the control unit), data related to the measurements performed on the field.

Further, first data 11 may comprise data related to the maintenance interventions performed on the switching device 500. Said maintenance interventions may comprise interventions performed in the past or just immediately before acquiring the data 11.

At processing step 202, the computerized means 3 generate a preliminary text file 101, in which the first data 11 and first text patterns 21 are paged in a plurality of sections that are arranged according to a selectable paging format.

According to the invention, text patterns 21 comprise first descriptive text strings describing the first data 11. Preferably, text patterns 21 are predefined text strings, which are stored in a memory of the computerised means 3. Advantageously, said text strings may be set or selected by the user through the user interface 6 before the computerised means 3 execute processing steps 201-204.

The text file 101 may be generated by a suitable file generating program that is activated by a software routine executed by the computerised means 3.

The text file 101 may be, for example, a document of the .pdf or .doc type or a web page. The text file 101 as generated defines the general structure of the life expectancy report 100 that will be obtained after the execution of the processing steps 201-207.

The paging format of the text file 101 may be selected among a plurality of predefined available paging formats that are stored in a memory by the computerised means 3. Preferably, each of said paging formats may be selected depending on means adopted to send the first data 11 to the computerised means 3 and depending on which values/parameters are comprised in the first data 11.

Preferably, the structure of the text file 101 may be selected among:
- a simplified paging format, which is selected when first data 11 are manually inserted by the user through the user interface 6 and the amount of data 11 is relatively poor. According to this paging format, the results of life expectancy analysis are expressed as rough predictive curves related to the future operating life of said switching device;
- an intermediate paging format, which is selected when first data 11 are inserted manually and do not comprise data related to any contextual maintenance interventions. According to this format, the results of life expectancy analysis are expressed as actual position on predictive curves related to said switching device;
- a full paging format, which is selected when first data 11 are fully complete. According to this paging format, the text file 101 comprises (preferably for each component of the switching device 500) sections describing the actual operating status of the switching device, sections describing the maintenance interventions performed on the switching device, sections describing the results of the life expectancy analysis including the most relevant predicted life indexes (e.g. electrical and mechanical life index) and showing the actual position on predictive curves related to the operating life of the switching device, sections describing the most relevant operating risks for the switching device and sections in which a maintenance plan for the switching device is proposed.

At processing step 203, the computerized means 3 calculate second data 12 related to the predicted life expectancy of the switching device 500, depending on said the first data 11. According to the invention, second data 12 comprises predictive life indexes related to the future operating life of the switching device, predictive curves related to the future operating life of the switching device, one or more first tables comprising data related to predicted operating risks for the switching device and one or more second tables comprising data related to suggested maintenance interventions intervals for the switching device.

Predictive life indexes may comprise, for example, a mechanical life index or an electrical life index.

Predictive curves related to the operating life of the switching device may comprise predictive aging curves of the switching device (and of the components thereof).

Data related predicted operating risks may include data related to the most probable aging risks for the relevant components of the switching device and/or data related to aging symptoms for said components.

Data related to suggested maintenance interventions may include data indicating ordinary and extraordinary maintenance interventions to perform, data indicating maintenance criticalities for each relevant component of the switching device, data indicating global maintenance criticalities for the switching device and/or data indicating a maintenance plan for the relevant component of the switching device.

At processing step 204, the computerized means 3 perform a classification of the first data 11, and/or the second data 12 received (or possibly calculated) by the computerised means 3. Preferably, in order to carry out this task, the computerized means 3 compare the first data 11, and/or the second data 12 with predefined threshold parameters (not shown), which are stored in a memory of the computerised means 3.

Advantageously, said threshold parameters may be set or selected by the user through the user interface 6 before the operation of the computerised means 3 start.

At processing step 205, the computerized means 3 select predefined second text patterns 22 and associate said second text patterns to the first data 11 and/or the second data 12.

The second text patterns 22 may comprise second descriptive text strings describing the first data 11 and/or the second data 12.

The second text patterns 22 may comprise classification text strings to describe the classification of the first data 11 and/or the second data 12.

According to the invention, the second text patterns 22 are predefined text strings, which are stored in a memory of the computerised means 3.

Advantageously, said text strings may be set, selected or updated by the manufacturer through the user interface 6 before the operation of the computerised means 3 starts.

According to the invention, the computerised means 3 associate the second text patterns 22 to the first data 11 and/or the second data 12 depending on the classification operated on the first data 11 and/or the second data 12.

By associating, the text patterns 22 to the first data 11 and/or the second data 12, the computerised means 3 may generate new information items to be inserted in the preliminary text file 101.

So, as an example, if a certain value "*A*" (e.g. included in data 11) is classified by the computerised means 3 as higher than a predefined threshold "*T*", said value may be associated to a predefined text pattern 22, e.g. to the classification text pattern *"Dangerous".* The result of the association operated by the computerised means 3 in a new information item, such as for example the string *"A > T, Dangerous",* which has to be subsequently inserted into the preliminary text file 101.

As an alternative, the computerised means 3 may create an association between the text patterns 22 and the first data 11 and/or the second data 12 only with the aim of properly paging these pieces of information into sections of the preliminary text file 101.

At processing step 206, the computerized means 3 merge the first data 11, the second data 12, the first patterns 21 and/or the second text patterns 22 (alone or comprised in newly generated information items) in corresponding sections of the preliminary text file 101.

The merging of pieces of information 11, 12, 21 and/or 22 is executed by the computerised means 3 in accordance to the paging format selected for the preliminary text file 101. Advantageously, each piece of information 11, 12, 21 and/or 22 to be merged in the preliminary text file 101 is selected depending on the paging format selected for this latter. By merging the initial content of the preliminary text file 101 with the mentioned pieces of information, the computerised means 3 provide a preliminary draft 100A of the life expectancy analysis report 100.

The preliminary draft 100A can be advantageously assessed through the user interface 6. In this way, a supervisor can decide to accept or reject the preliminary draft 100A.

The supervisor can check whether the described processing steps have provided inconsistent results, which, for example, may be determined by apparent errors in the acquired data 11.

If the preliminary draft 100A contains non-acceptable results, the user can introduce (by means of the user interface 6) corrections and amendments to the acquired data 11, according to the needs and the computerised means 3 automatically repeat (step 207) the described processing steps 202-206 to obtain a new preliminary draft 100A by using the newly amended or corrected data 11.

If necessary, the computerised means 3 may also repeat the step 201 to newly acquire the first data 11 in full.

If the preliminary draft 100A contains acceptable results, the computerised means 3 save (step 207) the preliminary draft 100A as the life expectancy analysis report 100. The report 100 is saved in its final version (preferably non-editable) in a permanent memory by the computerised means 3.

The computerized means 3 may also send or store the life expectancy analysis report 100 to/in a remote computerized device, according to the needs.

In some embodiments of the present invention, the computerized means 3, after having acquired the first data 11, may execute the additional processing step 208 of calculating further data 18 related to the operating status of the switching device 500.

Preferably, data 18 comprise second identification data of the switching device 500 that can be obtained by processing the first identification data of the switching device 500 included in the first data 11. Said second identification data may comprise, for example, the actual age of the switching device 500.

Data 18 may comprise also additional data related to the past operating life of the switching device 500 that can be obtained by processing the data related to the past operating life of the switching device, which are included in the first data 11.

Further data related to the past operating life of the switching device 500 may comprise, for example, the total number of manoeuvres operated by the switching device, the number of manoeuvres in which currents have been interrupted.

Advantageously, the computerized means 3 process the data 18 according to the steps 203-207 described above.

At processing step 203, the computerized means 3 may calculate the second data 12 also depending on the data 18.

Data 18 are classified, associated to selected second text patterns 22 and merged in corresponding sections of said preliminary text file 101 by said first computerised means, as for the described data 11, 12.

Preferably, in order to classify the data 18 the computerized means 3 compare them with predefined threshold parameters, which are stored in a memory of the computerised means 3. Preferably, the computerised means 3 associate predefined second text patterns 22 to the data 18 depending on the classification operated on said data 18.

According to the invention, the computerized system 1 comprises also at least a client computerized unit 4, which may be, for example, a computerized device (preferably of the portable type, e.g. a tablet or the like).

The computerized unit 4 comprises second computerized means 5, such as for example one or more microprocessors.

In order to operate (e.g. to perform the operations that will be described in the following), the computerized means 5 execute suitable second software instructions 51 that are stored in suitable storing means 52 (e.g. one or more volatile or non-volatile memories) comprised in the computerized means 5.

Software instructions 51 may be permanently stored in the storing means 52 or may be uploaded for execution by the computerized means 5 from one or more external devices (not shown).

Software instructions 51 are programmed by using suitable programming languages, according to the needs, and may be comprised in one or more applicative programs executed by the computerized means 5.

The computerized unit 4 preferably comprises a user interface 8 (e.g. a dedicated / portable HMI or test/programming unit), through which a user can send data or commands to the computerized means 5.

The computerized unit 4 preferably comprises one or more communication ports 9, through which the computerized means 5 can communicate with one or more remote computerized devices.

The computerized means 5 are capable to communicate with the first computerized unit 2, so that said first computerized means 3 can receive, at least partially, the first data 11 from a remote location.

For example, the computerised means 5 may execute a browsing program to communicate with the computerised unit 2 via the Internet or a LAN network.

Preferably, the computerized means 5 are further capable to communicate with the control unit 501 of the switching device 500 and to download at least a portion of the first data 11 from said control unit.

To this aim, the computerised means 5 may execute a suitable program to exchange data with the control unit 501 according to a predefined communication protocol (e.g. Bluetooh™ or Zigbee™).

In this preferred embodiment of the present invention, the computerized unit 2 may receive the first data 11 from a remote location in an automatic manner.

Most of the first data 11 may be directly downloaded from the control unit 501 of the switching device 500, with relevant savings of time.

The computerised system 1 may be subject to possible variants within the capacity of the skilled person.

For example, some of the described processing steps 201-208 (in particular the processing steps 202-208) may be executed by the computerized means 3 according to a different execution order from the one indicated above, depending on how software instructions 31 are programmed.

The values and/or parameters comprised in the first data 11, in the possible further data 18 and in the second data 12 may be different from those listed above.

Also, the paging formats for the preliminary text file 101 may be different from those described above.

Finally, also the computerized units 2 and 4 may be differently structured, according to the needs, provided that they comprise the respective computerized means 3, 5.

In a further aspect, the present invention relates to a method for generating the life expectancy analysis report 100 related to the low or medium voltage switching device 500.

The method, according to the invention, comprises the steps defined in claim 4.

The method, according to the invention, may comprise the step 208 of calculating further data 18 related to the operating status of the switching device 500.

Preferably, data 18 are classified, associated to selected second text patterns 22 and merged in corresponding sections of said preliminary text file 101.

Preferably, the second data 12 may be calculated depending on also the further data 18. Preferably, in the method according to the invention, the classification of the first data 11, the possible further data 18 and/or the second data 12 is performed by comparing said data with predefined threshold parameters.

Preferably, in the method according to the invention, the association between said second text patterns 22 and the first data 11, the possible further data 18 and/or the second data 12 is created depending on the classification of said data.

Preferably, in the method according to the invention, the first data 11 are received, at least partially, from a remote location.

Advantageously, by merging the initial content of the preliminary text file 101 with the pieces of information 11, (possibly 18), 12, 21 and/or 22, a preliminary draft 100A of the life expectancy analysis report 100 is obtained.

The method according to the invention comprises the step 207 of:
- repeating the previous steps 202-206 (and possibly 208) after the first data 11 have been corrected or amended or are newly acquired, if the preliminary draft 100A contains non-acceptable results; or
- saving the preliminary draft 100A to obtain the life expectancy analysis report 100, if the preliminary draft 100A contains non-acceptable results.

If necessary, also the step 201 may be repeated to newly acquire the first data 11 in full.

The computerised system and method, according to the invention, allow to perform a life expectancy analysis on a switching device and to automatically generate documentation reporting the results of said analysis, in which results are organized in a consistent manner, so as to be easily compared and looked-up.

The computerised system and method, according to the invention, effectively help the user to properly set a maintenance plan for the switching devices of a power distribution network with relevant savings of time and costs.

The computerised system and method, according to the invention, are of relatively easy and cost-effective realization at industrial level and practical implementation.

The computerised system and method, according to the invention, are particularly adapted for performing a life expectancy analysis of switching devices installed in digitally enabled power distribution networks (smart grids).

## Claims

1. A computerized system (1) for generating a life expectancy analysis report (100) related to a low or medium voltage switching device (500), said computerised system comprising a first computerized unit (2) comprising first computerized means (3) configured to execute first software instructions (31) and at least a client computerized unit (4) comprising second computerized means (5) configured to execute second software instructions (51) **characterized in that**:
- said first computerized means (3) are configured to acquire (201) first data (11) related to an operating status of said switching device, said first data being acquired from a user interface (6) or through a communication port (7) of said first computerised unit, said second computerised means (5) being configured to communicate with a control unit (501) of said switching device and to download, at least partially, said first data from said control unit, said second computerised means being configured to communicate with said first computerised unit, so that said data are received at least partially by said first computerised unit from a remote location;
- said first computerized means (3) are configured to generate (202) a preliminary text file (101), in which said first data and first text patterns (21) comprising-said first descriptive text strings describing said first data are paged in a plurality of sections arranged according to a selectable paging format, said preliminary text file defining the general structure of said life expectancy analysis report;
- said first computerized means (3) are configured to calculate (203) second data (12) related to a predicted life expectancy of said switching device, said second data being calculated depending on said first data (11) and comprising predictive indexes related to the future operating life of said switching device, predictive curves related to the future operating life of said switching device, one or more first tables comprising information related to predicted operating risks for said switching device and one or more second tables comprising information related to suggested maintenance interventions for said switching device;
- said first computerized means (3) are configured to perform (204) a classification of said first data (11) and/or said second data (12) by comparing said first data (11) and/or said second data (12) with predefined threshold parameters;
- said first computerized means (3) are configured to select (205) predefined second text patterns stored in a memory of said first computerised means and associate said second text patterns (22) to said first data (11) and/or said second data (12) depending on the classification operated on the first data (11) and/or the second data (12), said second text patterns (22) comprising second descriptive text strings describing said first data (11) and/or said second data (12) and/or classification text strings describing the classification of said first data (11) and/or said second data (12);
- said first computerized means (3) are configured to merge (206) said first data (11), said second data (12), said first text patterns (21) and/or said second text patterns (22) in corresponding sections of said preliminary text file (101), in accordance with a selected paging format;
wherein said preliminary text file (101) is assessed by a supervisor through the user interface (6) of said first computerised unit (2), said preliminary text file being accepted or rejected by said supervisor by checking whether inconsistent results have been produced by previous processing steps, said first data (11) being corrected or amended by a user, if said preliminary text file (101) comprises non-acceptable results for the supervisor;
- said first computerized means (3) are configured to repeat the previous processing steps using the new amended or corrected first data (11), if said preliminary text file (101) comprises non-acceptable results for the supervisor; or
- said first computerized means (3) are configured to save said preliminary text file (101) as said life expectancy analysis report (100) in a permanent memory, if said preliminary text file comprises acceptable results.

2. A computerized system (1), according to claim 1, **characterized in that** said first computerized means (3) are configured to calculate (208) further data (18) related to the operating status of said switching device, said further data being classified, associated to selected second text patterns (22) and merged in corresponding sections of said preliminary text file (101) by said first computerised means.

3. A computerized system (1), according to one or more of the preceding claims, **characterized in that** said first data (11) comprise:
- data related to the environmental operating conditions of said switching device;
- first identification data of said switching device; and/or
- first data related to the past operating life of said switching device; and/or
- data related to the maintenance interventions performed on said switching device.

4. A method for generating a life expectancy analysis report (100) related to a low or medium voltage switching device (500) in a computerised system comprising a first computerized unit (2) comprising first computerized means (3) configured to execute first software instructions (31) and at least a client computerized unit (4) comprising second computerized means (5) configured to execute second software instructions (51), **characterized in that** it comprises the following steps:
- a step (201) of acquiring, by said first computerised means (3), first data (11) related to an operating status of said switching device, said first data being acquired from a user interface (6) or through a communication port (7) of said first computerised unit, said second computerised means (5) communicating with a control unit (501) of said switching device and downloading, at least partially, said first data from said control unit, said second computerised means communicating with said first computerised unit, so that said data are received at least partially by said first computerised unit from a remote location;
- a step (202) of generating , by said first computerised means (3), a preliminary text file (101), in which said first data and first text patterns (21) comprising first descriptive text strings describing said first data are paged in a plurality of sections arranged according to a selectable paging format, said preliminary text file defining the general structure of said life expectancy analysis report;
- a step (203) of calculating , by said first computerised means (3), second data (12) related to the predicted life expectancy of said switching device, said second data being calculated depending on said first data (11) and comprising predictive indexes related to the future operating life of said switching device, predictive curves related to the future operating life of said switching device, one or more first tables comprising information related to predicted operating risks for said switching device and one or more second tables comprising information related to suggested maintenance interventions for said switching device;
- a step (204) of performing , by said first computerised means (3), a classification of said first data (11) and/or said second data (12) by comparing said first data (11) and/or said second data (12) with predefined threshold parameters;
- a step (205) of selecting , by said first computerised means (3), predefined second text patterns (22) stored in a memory of said first computerised means and associating said second text patterns (22) to said first data (11) and/or said second data depending on the classification operated on the first data (11) and/or the second data (12) said second text patterns (22) comprising second descriptive text strings describing said first data (11) and/or said second data (12) and/or classification text strings describing the classification of said first data (11) and/or said second data (12);
- a step (206) of merging, by said first computerised means (3), said first data (11), said second data (12), said first patterns (21) and/or said second text patterns (22) in corresponding sections of said preliminary text file (101);
wherein said preliminary text file (101) is assessed by a supervisor through the user interface (6) of said first computerised unit (2), said preliminary text file being accepted or rejected by said supervisor by checking whether inconsistent results have been produced by previous processing steps, said first data (11) being corrected or amended by a user, if said preliminary text file (101) comprises non-acceptable results for the supervisor;
- a step (207) of repeating, by said first computerised means (3), the previous processing steps, if said preliminary text file (101) comprises non-acceptable results for the supervisor or saving , by said first computerised means (3), said preliminary text file (101) as said life expectancy analysis report (100) in a permanent memory, if said life expectancy analysis report (100) comprises acceptable results.

5. A method, according to claim 4, **characterized in that** it comprises a step (208) of calculating, by said first computerised means (3), further data (18) related to the operating status of said switching device, said further data being classified, associated to selected second text patterns (22) and merged in corresponding sections of said preliminary text file (101), by said first computerised means.

## Patentansprüche

1. Computerbasiertes System (1) zum Erzeugen eines Lebenserwartungsanalyseberichts (100) in Bezug auf eine Nieder- oder Mittelspannungsschaltvorrichtung (500), wobei das computerbasierte System eine erste computerbasierte Einheit (2), die erste computerbasierte Mittel (3) umfasst, die zum Ausführen erster Softwareanweisungen (31) konfiguriert sind, und mindestens eine computerbasierte Client-Einheit (4) umfasst, die zweite computerbasierte Mittel (5) umfasst, die zum Ausführen zweiter Softwareanweisungen (51) konfiguriert sind, **dadurch gekennzeichnet, dass**:
- die erste computerbasierten Mittel (3) zum Erfassen (201) von ersten Daten (11) in Bezug auf einen Betriebsstatus der Schaltvorrichtung konfiguriert sind, wobei die ersten Daten von einer Benutzerschnittstelle (6) oder durch einen Kommunikationsport (7) der ersten computerbasierten Einheit erfasst werden, die zweiten computerbasierten Mittel (5) zum Kommunizieren mit einer Steuereinheit (501) der Schaltvorrichtung und zum wenigstens teilweisen Herunterladen der ersten Daten von der Steuereinheit konfiguriert sind, und die zweiten computerbasierten Mittel zum Kommunizieren mit der ersten computerbasierten Einheit konfiguriert sind, so dass die Daten wenigstens teilweise durch die erste computerbasierte Einheit von einem entfernten Ort empfangen werden;
- die ersten computerbasierten Mittel (3) zum Erzeugen (202) einer vorläufigen Textdatei (101) konfiguriert sind, in welcher die ersten Daten und erste Textmuster (21), die erste Beschreibungstextzeichenfolgen umfassen, welche die ersten Daten beschreiben, in eine Mehrzahl von Abschnitten ausgelagert werden, die gemäß einem ausgewählten Paging-Format angeordnet sind, wobei die vorläufige Textdatei die allgemeine Struktur des Lebenserwartungsanalyseberichts definiert;
- die ersten computerbasierten Mittel (3) zum Berechnen (203) von zweiten Daten (12) in Bezug auf eine vorhergesagte Lebenserwartung der Schaltvorrichtung konfiguriert sind, wobei die zweiten Daten unabhängig von den ersten Daten (11) berechnet werden und Vorhersageindizes in Bezug auf die zukünftige Betriebslebensdauer der Schaltvorrichtung, Vorhersagekurven in Bezug auf die zukünftige Betriebslebensdauer der Schaltvorrichtung, eine oder mehrere erste Tabellen, die Informationen in Bezug auf vorhergesagte Betriebsrisiken für die Schaltvorrichtung umfassen, und eine oder mehrere zweite Tabellen umfassen, die Informationen in Bezug auf empfohlene Wartungsmaßnahmen für die Schaltvorrichtung umfassen;
- die ersten computerbasierten Mittel (3) zum Durchführen (204) einer Klassifizierung der ersten Daten (11) und/oder der zweiten Daten (12) durch Vergleichen der ersten Daten (11) und der zweiten Daten (12) mit vordefinierten Schwellenparametern konfiguriert sind;
- die ersten computerbasierten Mittel (3) zum Auswählen (205) vordefinierter zweiter Textmuster, die in einem Speicher der ersten computerbasierten Mittel gespeichert sind, und Assoziieren der zweiten Textmuster (22) mit den ersten Daten (11) und/oder den zweiten Daten (12) in Abhängigkeit von der an den ersten Daten (11) und/oder den zweiten Daten (12) vorgenommenen Klassifizierung konfiguriert sind, wobei die zweiten Textmuster (22) zweite Beschreibungstextzeichenfolgen, welche die ersten Daten (11) und/oder die zweiten Daten (12) beschreiben, und/oder Klassifizierungstextzeichenfolgen umfassen, welche die Klassifizierung der ersten Daten (11) und/oder der zweiten Daten (12) beschreiben;
- die ersten computerbasierten Mittel (3) zum Zusammenführen (206) der ersten Daten (11), der zweiten Daten (12), der ersten Textmuster (21) und/oder der zweiten Textmuster (22) in entsprechenden Abschnitten der vorläufigen Textdatei (101) gemäß einem ausgewählten Paging-Format konfiguriert sind;
wobei die vorläufige Textdatei (101) von einem Supervisor durch die Benutzerschnittstelle (6) der ersten computerbasierten Einheit (2) beurteilt wird, wobei die vorläufige Textdatei vom Supervisor durch Prüfen, ob durch die vorherigen Verarbeitungsschritte widersprüchliche Ergebnisse erzeugt wurden, angenommen oder abgelehnt wird, wobei die ersten Daten (11) von einem Benutzer korrigiert oder geändert werden, wenn die vorläufige Textdatei (101) Ergebnisse umfasst, die für den Supervisor nicht annehmbar sind;
- die ersten computerbasierten Mittel (3) zum Wiederholen der vorherigen Verarbeitungsschritte unter Verwendung der neuen geänderten oder korrigierten ersten Daten (11) konfiguriert sind, wenn die vorläufige Textdatei (101) Ergebnisse umfasst, die für den Supervisor nicht annehmbar sind; oder
- die ersten computerbasierten Mittel (3) zum Speichern der vorläufigen Textdatei (101) als den Lebenserwartungsanalysebericht (100) in einem permanenten Speicher konfiguriert sind, wenn die vorläufige Textdatei annehmbare Ergebnisse umfasst.

2. Computerbasiertes System (1) nach Anspruch 1, **dadurch gekennzeichnet, dass** die ersten computerbasierten Mittel (3) zum Berechnen (208) weiterer Daten (18) in Bezug auf den Betriebsstatus der Schaltvorrichtung konfiguriert sind, wobei die weiteren Daten durch die ersten computerbasierten Mittel ferner klassifiziert, mit ausgewählten zweiten Textmustern (22) assoziiert and in entsprechenden Abschnitten der vorläufigen Textdatei (101) zusammengeführt werden.

3. Computerbasiertes System (1) nach einem der vorhergehenden Ansprüche, **dadurch gekennzeichnet, dass** die ersten Daten (11) umfassen:
- Daten in Bezug auf Betriebsumgebungsbedingungen der Schaltvorrichtung;
- erste Identifikationsdaten der Schaltvorrichtung; und/oder
- erste Daten in Bezug auf die vergangene Betriebslebensdauer der Schaltvorrichtung; und/oder
- Daten in Bezug auf Wartungsmaßnahmen, die an der Schaltvorrichtung durchgeführt wurden.

4. Verfahren zur Erzeugung eines Lebenserwartungsanalyseberichts (100) in Bezug auf eine Nieder- oder Mittelspannungsschaltvorrichtung (500) in einem computerbasierten System, das eine erste computerbasierte Einheit (2), die erste computerbasierte Mittel (3) umfasst, die zum Ausführen erster Softwareanweisungen (31) konfiguriert sind, und mindestens eine computerbasierte Client-Einheit (4) umfasst, die zweite computerbasierte Mittel (5) umfasst, die zum Ausführen zweiter Softwareanweisungen (51) konfiguriert sind, **dadurch gekennzeichnet, dass** es die folgenden Schritte umfasst:
- einen Schritt (201) zum Erfassen von ersten Daten (11) in Bezug auf einen Betriebsstatus der Schaltvorrichtung durch die ersten computerbasierten Mittel (3), wobei die ersten Daten von einer Benutzerschnittstelle (6) oder durch einen Kommunikationsport (7) der ersten computerbasierten Einheit erfasst werden, die zweiten computerbasierten Mittel (5) mit einer Steuereinheit (501) der Schaltvorrichtung kommunizieren und die ersten Daten wenigstens teilweise von der Steuereinheit herunterladen, und die zweiten computerbasierten Mittel mit der ersten computerbasierten Einheit kommunizieren, so dass die Daten wenigstens teilweise durch die erste computerbasierte Einheit von einem entfernten Ort empfangen werden;
- einen Schritt (202) zum Erzeugen einer vorläufigen Textdatei (101) durch die ersten computergestützten Mittel (3), in welcher die ersten Daten und erste Textmuster (21), die erste Beschreibungstextzeichenfolgen umfassen, welche die ersten Daten beschreiben, in eine Mehrzahl von Abschnitten ausgelagert werden, die gemäß einem ausgewählten Paging-Format angeordnet sind, wobei die vorläufige Textdatei die allgemeine Struktur des Lebenserwartungsanalyseberichts definiert;
- einen Schritt (203) zum Berechnen von zweiten Daten (12) in Bezug auf die vorhergesagte Lebenserwartung der Schaltvorrichtung durch die ersten computerbasierten Mittel (3), wobei die zweiten Daten unabhängig von den ersten Daten (11) berechnet werden und Vorhersageindizes in Bezug auf die zukünftige Betriebslebensdauer der Schaltvorrichtung, Vorhersagekurven in Bezug auf die zukünftige Betriebslebensdauer der Schaltvorrichtung, eine oder mehrere erste Tabellen, die Informationen in Bezug auf vorhergesagte Betriebsrisiken für die Schaltvorrichtung umfassen, und eine oder mehrere zweite Tabellen umfassen, die Informationen in Bezug auf empfohlene Wartungsmaßnahmen für die Schaltvorrichtung umfassen;
- einen Schritt (204) zum Durchführen einer Klassifizierung der ersten Daten (11) und/oder der zweiten Daten (12) durch die ersten computerbasierten Mittel (3) durch Vergleichen der ersten Daten (11) und der zweiten Daten (12) mit vordefinierten Schwellenparametern;
- einen Schritt (205) zum Auswählen vordefinierter zweiter Textmuster (22), die in einem Speicher der ersten computerbasierten Mittel gespeichert sind, und Assoziieren der zweiten Textmuster (22) mit den ersten Daten (11) und/oder den zweiten Daten in Abhängigkeit von der an den ersten Daten (11) und/oder den zweiten Daten (12) vorgenommenen Klassifizierung durch die ersten computerbasierten Mittel (3), wobei die zweiten Textmuster (22) zweite Beschreibungstextzeichenfolgen, welche die ersten Daten (11) und/oder die zweiten Daten (12) beschreiben, und/oder Klassifizierungstextzeichenfolgen umfassen, welche die Klassifizierung der ersten Daten (11) und/oder der zweiten Daten (12) beschreiben;
- einen Schritt (206) zum Zusammenführen der ersten Daten (11), der zweiten Daten (12), der ersten Textmuster (21) und/oder der zweiten Textmuster (22) in entsprechenden Abschnitten der vorläufigen Textdatei (101) durch die ersten computerbasierten Mittel (3) gemäß dem ausgewählten Paging-Format;
wobei die vorläufige Textdatei (101) von einem Supervisor durch die Benutzerschnittstelle (6) der ersten computerbasierten Einheit (2) beurteilt wird, wobei die vorläufige Textdatei vom Supervisor durch Prüfen, ob durch die vorherigen Verarbeitungsschritte widersprüchliche Ergebnisse erzeugt wurden, angenommen oder abgelehnt wird, wobei die ersten Daten (11) von einem Benutzer korrigiert oder geändert werden, wenn die vorläufige Textdatei (101) Ergebnisse umfasst, die für den Supervisor nicht annehmbar sind;
- einen Schritt (207) zum Wiederholen der vorherigen Verarbeitungsschritte durch die ersten computerbasierten Mittel (3), wenn die vorläufige Textdatei (101) Ergebnisse umfasst, die für den Supervisor nicht annehmbar sind, oder Speichern der vorläufigen Textdatei (101) als den Lebenserwartungsanalysebericht (100) in einem permanenten Speicher durch die ersten computerbasierten Mittel (3), wenn der Lebenserwartungsanalysebericht (100) annehmbare Ergebnisse umfasst.

5. Verfahren nach Anspruch 4, **dadurch gekennzeichnet, dass** es einen Schritt (208) zum Berechnen weiterer Daten (18) in Bezug auf den Betriebsstatus der Schaltvorrichtung durch die ersten computerbasierten Mittel (3) umfasst, wobei die weiteren Daten durch die ersten computerbasierten Mittel ferner klassifiziert, mit ausgewählten zweiten Textmustern (22) assoziiert und in entsprechenden Abschnitten der vorläufigen Textdatei (101) zusammengeführt werden.

## Revendications

1. Système informatisé (1) permettant de générer un rapport d'analyse de l'espérance de vie (100) se rapportant à un dispositif de commutation basse ou moyenne tension (500), ledit système informatisé comprenant une première unité informatisée (2) comprenant des premiers moyens informatisés (3) configurés pour exécuter des premières instructions logicielles (31) et au moins une unité informatisée cliente (4) comprenant des seconds moyens informatisés (5) configurés pour exécuter des secondes instructions logicielles (51), **caractérisé en ce que** :
- lesdits premiers moyens informatisés (3) sont configurés pour acquérir (201) des premières données (11) se rapportant à un état de fonctionnement dudit dispositif de commutation, lesdites premières données étant acquises depuis une interface utilisateur (6) ou par l'intermédiaire d'un port de communication (7) de ladite première unité informatisée, lesdits seconds moyens informatisés (5) étant configurés pour communiquer avec une unité de commande (501) dudit dispositif de commutation et pour télécharger, au moins partiellement, lesdites premières données depuis ladite unité de commande, lesdits seconds moyens informatisés étant configurés pour communiquer avec ladite première unité informatisée, de sorte que lesdites données soient reçues au moins partiellement par ladite première unité informatisée en provenance d'un emplacement distant ;
- lesdits premiers moyens informatisés (3) sont configurés pour générer (202) un fichier texte préliminaire (101), dans lequel lesdites premières données et lesdits premiers modèles de texte (21) comprenant des premières chaînes de texte descriptif décrivant lesdites premières données sont paginés dans une pluralité de sections agencées en fonction d'un format de pagination sélectionnable, ledit fichier texte préliminaire définissant la structure générale dudit rapport d'analyse d'espérance de vie ;
- lesdits premiers moyens informatisés (3) sont configurés pour calculer (203) des secondes données (12) se rapportant à une espérance de vie prédite dudit dispositif de commutation, lesdites secondes données étant calculées en fonction desdites premières données (11) et comprenant des indices prédictifs se rapportant à la future durée de vie utile dudit dispositif de commutation, des courbes prédictives se rapportant à la future durée de vie utile dudit dispositif de commutation, une ou plusieurs tables comprenant des informations se rapportant à des risques fonctionnels prédits pour ledit dispositif de commutation et une ou plusieurs secondes tables comprenant des informations se rapportant à des interventions de maintenance suggérées pour ledit dispositif de commutation ;
- lesdits premiers moyens informatisés (3) sont configurés pour réaliser (204) une classification desdites premières données (11) et/ou desdites secondes données (12) en comparant lesdites premières données (11) et/ou lesdites secondes données (12) avec des paramètres seuils prédéfinis ;
- lesdits premiers moyens informatisés (3) sont configurés pour sélectionner (205) des seconds modèles de texte prédéfinis mémorisés dans une mémoire desdits premiers moyens informatisés et pour associer lesdits seconds modèles de texte (22) auxdites premières données (11) et/ou auxdites secondes données (12) en fonction de la classification effectuée sur les premières données (11) et/ou les secondes données (12), lesdits seconds modèles de texte (22) comprenant des secondes chaînes de texte descriptif décrivant lesdites premières données (11) et/ou lesdites secondes données (12) et/ou des chaînes de texte de classification décrivant la classification desdites premières données (11) et/ou desdites secondes données(12) ;
- lesdits premiers moyens informatisés (3) sont configurés pour fusionner (206) lesdites premières données (11), lesdites secondes données (12), lesdits premiers modèles de texte (21) et/ou lesdits seconds modèles de texte (22) dans des sections correspondantes dudit fichier texte préliminaire (101), en fonction d'un format de pagination sélectionné ;
dans lequel ledit fichier texte préliminaire (101) est évalué par un superviseur au moyen de l'interface utilisateur (6) de ladite première unité informatisée (2), ledit fichier texte préliminaire étant accepté ou refusé par ledit superviseur en vérifiant si des résultats incohérents ont été produits par des étapes de traitement précédentes, lesdites premières données (11) étant corrigées ou amendées par un utilisateur, si ledit fichier texte préliminaire (101) comprend des résultats non acceptables pour le superviseur ;
- lesdits premiers moyens informatisés (3) sont configurés pour répéter les étapes de traitement précédentes en utilisant les nouvelles premières données amendées ou corrigées (11), si ledit fichier texte préliminaire (101) comprend des résultats non acceptables pour le superviseur ; ou
- lesdits premiers moyens informatisés (3) sont configurés pour enregistrer ledit fichier texte préliminaire (101) sous la forme dudit rapport d'analyse d'espérance de vie (100) dans une mémoire permanente, si ledit fichier texte préliminaire comprend des résultats acceptables.

2. Système informatisé (1), selon la revendication 1, **caractérisé en ce que** lesdits premiers moyens informatisés (3) sont configurés pour calculer (208) des données supplémentaires (18) se rapportant à l'état de fonctionnement dudit dispositif de commutation, lesdites données supplémentaires étant classées, associées à des seconds modèles de texte sélectionnés (22) et fusionnées dans des sections correspondantes dudit fichier texte préliminaire (101) par lesdits premiers moyens informatisés.

3. Système informatisé (1), selon une ou plusieurs des revendications précédentes, **caractérisé en ce que** lesdites premières données (11) comprennent :
- des données se rapportant aux conditions de fonctionnement environnementales dudit dispositif de commutation ;
- des premières données d'identification dudit dispositif de commutation ; et/ou
- des premières données se rapportant à la durée de vie utile passée dudit dispositif de commutation ; et/ou
- des données se rapportant aux interventions de maintenance réalisées sur ledit dispositif de commutation.

4. Procédé permettant de générer un rapport d'analyse de l'espérance de vie (100) se rapportant à un dispositif de commutation basse ou moyenne tension (500) dans un système informatisé comprenant une première unité informatisée (2) comprenant des premiers moyens informatisés (3) configurés pour exécuter des premières instructions logicielles (31) et au moins une unité informatisée cliente (4) comprenant des seconds moyens informatisés (5) configurés pour exécuter des secondes instructions logicielles (51), **caractérisé en ce qu'**il comprend les étapes suivantes :
- une étape (201) consistant à acquérir, par lesdits premiers moyens informatisés (3), des premières données (11) se rapportant à un état de fonctionnement dudit dispositif de commutation, lesdites premières données étant acquises depuis une interface utilisateur (6) ou par l'intermédiaire d'un port de communication (7) de ladite première unité informatisée, lesdits seconds moyens informatisés (5) communiquant avec une unité de commande (501) dudit dispositif de commutation et téléchargeant, au moins partiellement, lesdites premières données à partir de ladite unité de commande, lesdits seconds moyens informatisés communiquant avec ladite première unité informatisée, de sorte que lesdites données soient reçues au moins partiellement par ladite première unité informatisée en provenance d'un emplacement distant ;
- une étape (202) consistant à générer, par lesdits premiers moyens informatisés (3), un fichier texte préliminaire (101), dans lequel lesdites premières données et lesdits premiers modèles de texte (21) comprenant des premières chaînes de texte descriptif décrivant lesdites premières données sont paginés dans une pluralité de sections agencées en fonction d'un format de pagination sélectionnable, ledit fichier texte préliminaire définissant la structure générale dudit rapport d'analyse d'espérance de vie ;
- une étape (203) consistant à calculer, par lesdits premiers moyens informatisés (3), des secondes données (12) se rapportant à la durée de vie prédite dudit dispositif de commutation, lesdites secondes données étant calculées en fonction desdites premières données (11) et comprenant des indices prédictifs se rapportant à la future durée de vie utile dudit dispositif de commutation, des courbes prédictives se rapportant à la future durée de vie utile dudit dispositif de commutation, une ou plusieurs tables comprenant des informations se rapportant à des risques de fonctionnement prédits pour ledit dispositif de commutation et une ou plusieurs secondes tables comprenant des informations se rapportant à des interventions de maintenance suggérées pour ledit dispositif de commutation ;
- une étape (204) consistant à réaliser, par lesdits premiers moyens informatisés (3), une classification desdites premières données (11) et/ou desdites secondes données (12) en comparant lesdites premières données (11) et/ou lesdites secondes données (12) avec des paramètres seuils prédéfinis ;
- une étape (205) consistant à sélectionner, par lesdits premiers moyens informatisés (3), des seconds modèles de texte prédéfinis (22) mémorisés dans une mémoire desdits premiers moyens informatisés et à associer lesdits seconds modèles de texte (22) auxdites premières données (11) et/ou auxdites secondes données en fonction de la classification effectuée sur les premières données (11) et/ou les secondes données (12), lesdits seconds modèles de texte (22) comprenant des secondes chaînes de texte descriptif décrivant lesdites premières données (11) et/ou lesdites secondes données (12) et/ou des chaînes de texte de classification décrivant la classification desdites premières données (11) et/ou desdites secondes données(12) ;
- une étape (206) consistant à fusionner, par lesdits premiers moyens informatisés (3), lesdites premières données (11), lesdites secondes données (12), lesdits premiers modèles (21) et/ou lesdits seconds modèles de texte (22) dans des sections correspondantes dudit fichier texte préliminaire (101) ;
dans lequel ledit fichier texte préliminaire (101) est évalué par un superviseur au moyen de l'interface utilisateur (6) de ladite première unité informatisée (2), ledit fichier texte préliminaire étant accepté ou refusé par ledit superviseur en vérifiant si des résultats incohérents ont été produits par des étapes de traitement précédentes, lesdites premières données (11) étant corrigées ou amendées par un utilisateur, si ledit fichier texte préliminaire (101) comprend des résultats non acceptables pour le superviseur ;
- une étape (207) consistant à répéter, par lesdits premiers moyens informatisés (3), les étapes de traitement précédentes, si ledit fichier texte préliminaire (101) comprend des résultats non acceptables pour le superviseur ou à enregistrer, par lesdits premiers moyens informatisés (3), ledit fichier texte préliminaire (101) sous la forme dudit rapport d'analyse d'espérance de vie (100) dans une mémoire permanente, si ledit rapport d'analyse d'espérance de vie (100) comprend des résultats acceptables.

5. Procédé, selon la revendication 4, **caractérisé en ce qu'**il comprend une étape (208) consistant à calculer, par lesdits premiers moyens informatisés (3), des données supplémentaires (18) se rapportant à l'état de fonctionnement dudit dispositif de commutation, lesdites données supplémentaires étant classées, associées à des seconds modèles de texte sélectionnés (22) et fusionnées dans des sections correspondantes dudit fichier texte préliminaire (101), par lesdits premiers moyens informatisés.
